(19) Europäisches Patentamt

European Patent Office

Office européen des brevets

(11) EP 0 536 682 B1

(12) **EUROPÄISCHE PATENTSCHRIFT**

(45) Veröffentlichungstag und Bekanntmachung des Hinweises auf die Patenterteilung:
**19.07.2000 Patentblatt 2000/29**

(51) Int. Cl.[7]: **H01L 31/0392**, H01L 31/18, H01L 31/068, H01L 31/0236

(21) Anmeldenummer: **92117007.2**

(22) Anmeldetag: **06.10.1992**

(54) **Verfahren zur Herstellung eines Halbleiter-Bauelements**

Process of manufacturing a semiconductor device

Procédé de fabrication d'un dispositif semiconducteur

(84) Benannte Vertragsstaaten:
**AT BE CH DE FR GB IT LI**

(30) Priorität: **11.10.1991 DE 4133644**

(43) Veröffentlichungstag der Anmeldung:
**14.04.1993 Patentblatt 1993/15**

(73) Patentinhaber:
**Angewandte Solarenergie - ASE GmbH
63755 Alzenau (DE)**

(72) Erfinder:
- **Von Campe, Hilmar, Dr.
  W-6380 Bad Homburg (DE)**
- **Ebinger, Horst
  W-6483 Salmünster (DE)**
- **Nikl, Dieter, Dr.
  W-6233 Kelkheim (DE)**
- **Warzawa, Wolfgang
  W-6450 Hanau (DE)**

(74) Vertreter:
**Stoffregen, Hans-Herbert, Dr. Dipl.-Phys. et al
Patentanwalt
Postfach 21 44
63411 Hanau (DE)**

(56) Entgegenhaltungen:
**US-A- 4 077 818     US-A- 4 137 355**

- **EXTENDED ABSTRACTS Bd. 80-1, Nr. 332, Mai 1980, PRINCETON, NEW JERSEY US Seiten 827 - 828 G.A. VAN DER LEEDEN ET AL. 'The recrystallization of silicon on graphite'**
- **ELECTRONICS Bd. 60, Nr. 10, 14. Mai 1987, NEW YORK US Seite 22 'ceramic cuts solar cell costs to 16 cents per watt'**
- **SEVENTEENTH IEEE PHOTOVOLTAIC SPECIALISTS CONFERENCE, Kissimmee, Florida, 1-4 Mai 1984, Seiten 275-280, IEEE, New York, US; M. KERBER et al. : "Large grain polycrystalline silicon films on graphite for solar cell applications."**
- **FOURTEENTH IEEE PHOTOVOLTAIC SPECIALISTS CONFERENCE, San Diego, California, 7-10 Januar 1980, Seiten 391-396, IEEE, New York, US; CHARLES FELDMAN et al. : "Vacuum deposited polycrystalline silicon solar cells for terrestrial use."**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung bezieht sich auf ein Verfahren zur Herstellung eines Halbleiterbaueleints, insbesondere Dünnschicht-Halbleiterbauelements wie Dünnschicht-Solarzelle, umfassend einen Träger, erste und zweite elektrisch leitende Front- bzw. Rückkontakt bildende Kontakte sowie zumindest eine zwischen diesen vorhandene Halbleiterschicht sowie eine zwischen der Halbleiterschicht und dem Träger angeordnete Keimbildungschicht, die nach dem Auftragen zunächst lateral kristallisiert wird, um anschließend die Halbleiterschicht epitaktisch auf die Keimbildungsschicht abzuscheiden.

Zur Herstellung großflächiger Halbleiter-Bauelemente, insbesondere Solarzellen oder Dünnschichttransistor-Anordnungen, wird eine Kostendegression durch Etablierung eines wirtschaftlichen Herstellungprozesses angestrebt. Dies wird dadurch versucht, daß man die halbleitende Substanz in Form einer dünnen Schicht auf billige Träger (Substrate) abscheidet. Im Falle des amorphen Siliciums als Halbleiterschicht wurden erhebliche Anstrengungen unternommen. Trotz aller Erfolge bleibt das Problem der Stabilität der Bauelemente nur unbefriedigend gelöst.

Alternativ dazu geht man den Weg, polykristallines Silicium in Form dünner Schichten auf einem Träger aufzubringen. Hiervon verspricht man sich, daß Stabilitätsprobleme weitgehend entfallen.

Da kristallines Silicium als indirekter Halbleiter eine kleinere Absorptionskonstante als amorphes Silicium besitzt, werden in der herkömmlichen Wafer-Technologie Schichtdicken von mehr als 200 µm für eine effiziente Absorption des Sonnenlichtes verwendet.

Götzberger, Proc. 15th IEEE Photovolt. Spec. Conf. 1981, Kissimee, FL, USA, p. 867, weist einen Weg, über einen diffusen Rückseitenreflektor schon bei Schichtdicken um 5 - 20 µm eine effiziente Lichtabsorption zu erhalten. Knobloch, Voss u. Götzberger, Proc. 15th EC Photovolt. Solar Energy Conf., Apr. 15 - 19, 1985, London, p. 285, errechnen für eine kristalline Dünnschichtsolarzelle einen theoretisch möglichen Wirkungsgrad von 25 %.

Damit die durch Licht generierten Ladungsträger das elektrische Feld des Halbleiterelements (speziell der Solarzelle) erreichen, muß die Diffusionslänge des Basismaterials ausreichend hoch sein.

In den Rechnungen von Knobloch, Voss und Götzberger, Proc. 15th EC Photovolt. Solar Energy Conf., Apr. 15 - 19, 1985, London, p. 285, wird gezeigt, daß Diffusionslängen von $L_D$ = 50 µm für Schichtdicken von 20 µm, $L_D$ = 30 µm für Schichtdicken von 10 µm, und $L_D$ = 20 µm für Schichtdicken von 5 µm erforderlich sind, um einen guten Sammel-Wirkungsgrad zu erhalten. Da sich an Oberflächen und Korngrenzen in polykristallinem Silicium Rekombinationszentren bilden, sind zwei Voraussetzungen für die Funktion einer Dünnschichtsolarzelle zu erfüllen, erstens eine gute Passivierung der Grenzflächen (Oberflächenpassivierung, insbesondere Rückseitenpassivierung), zweitens Korngrenzenpassivierung oder große Körner mit $G \approx 2 - 4 \cdot L_D$ (G = Korngröße). Aus obigem resultiert die Forderung an eine Korngröße von 100 µm - 200 µm für polykristallines Silicium in der Dünnschichtsolarzelle, bzw. die Forderung nach einer effektiven und stabilen Passivierung der Korngrenzenzustände. Zusätzlich müssen die Korngrenzen senkrecht zur Substratoberfläche ausgerichtet sein.

Darüber hinaus sind Vorder- und Rückseite der Zelle durch geeignete Maßnahmen zu passivieren.

Die praktische Realisierung dieses Konzepts stößt auf Schwierigkeiten prinzipieller Natur, da bei der Abscheidung dünner kristalliner Silicium-Schichten auf nicht-einkristalline Substrate die hohe Keimbildungsrate kolumnares, feinkörniges Wachstum bewirkt.

Die vielfältig in der Literatur beschriebenen Verfahren zur Abscheidung von Siliciumschichten, wie Elektronenstrahlverdampfung, P. H. Fang, C. C. Schubert, J. H. Kinnier, Dawen Pang, Appl. Phys. Lett. 39 (1981) 256; Charles Feldman, N. A. Blum, F. Satkiewicz, Proc. 14th IEEE Photovolt. Spec. Conf. 1980, San Diego, p. 391; R. J. C. van Zolingen, A. H. Kipperman, Thin Solid Films, 58 (1979) 89, und thermische CVD-Verfahren durch Reduktion diverser Chlorsilanverbindungen mit Wasserstoff bei Temperaturen von 1100 - 1300 °C führen bei Verwendungen von Fremdsubstraten zum Wachstum von maximal 20 - 30 µm großen Körnern.

Durch längeres Tempern bei höheren Temperaturen kann eine gewisse Rekristallisation in Siliciumschichten zur Ausbildung größerer Körner führen, C. Daey Ouwens, H. Heijligers, Appl. Phys. Lett. 26 (1975) 569. In diesem Falle werden Korngrößen bis zu 100 µm erhalten, jedoch nur bei Temperzeiten von 10 h und Temperaturen von über 1350 °C. Unter solchen Bedingungen ist mit starker Diffusion von Verunreinigungen aus dem Substrat in die Silicium-Schicht zu rechnen, die die Qualität der Solarzelle herabsetzen.

Wesentlich größere Kristalle werden erhalten, wenn man Siliciumschichten epitaktisch auf multikristallinen Silicium-Wafern mit Korngrößen oberhalb von Millimetern abscheidet, T. Warabisako, T. Saitoh, H. Itoh, N. Nakamura, T. Tokuyama, Jpn. J. Appl. Phys., 17 Suppl. (1978) 309; P. H. Robinson, R. V. D'Aiello, D. Richman, B. W. Faughnan, Proc. 13th IEEE Photovolt, Spec. Conf. 1978, Washington, DC, p. 1111.

T. Warabisako et al., Jpn. J. Appl. Phys., 17 Suppl. (1978) 309, verwenden Substrate aus polykristallinem Silicium von metallurgischem Reinheitsgrad, die nach Czochralski gezogen und in 0,4 mm dicke Scheiben gesägt wurden. Auf solchen Scheiben wird eine 20 - 30 µm dicke p-Si-Schicht durch Reduktion von $SiH_2Cl_2$ mit $H_2$ bei 1100 - 1150 °C und eine 0,5 µm dicke n[+]-dotierte Si-Schicht bei 1000 - 1050 °C abgeschieden. Ähnlich verfahren P. H. Robinson et al., Proc.

13th IEEE Photovolt. Spec. Conf. 1978, Washington, DC, p. 1111. Bei diesen, Prozeß entfällt allerdings der wirtschaftliche Vorteil, da die Siliciumscheiben gesondert hergestellt werden müssen.

T. L. Chu, S. S. Chu, K. Y. Duh, H. C. Mollenkopf, J. Appl. Phys. 48 (1977) 3576, benutzen als Grundlage für die epitaktische Silicium-Abscheidung eine ca. 200 - 500 µm dicke Silicium-Schicht (p-dotiert, 0,002 - 0,004 $\Omega$ cm) auf einem Graphit-Substrat. Diese Schicht wird durch Reduktion von $SiHCl_3$ mit $H_2$ erzeugt.

Zur Herstellung großer Körner werden die Schichten in einem zweiten Prozeß aufgeschmolzen und kristallisiert. Hinderlich dabei ist die hohe Oberflächenspannung von Silicium, die zur Folge hat, daß sich die Schmelze auf dem Substrat zu Tropfen zusammenzieht, so daß die Schmelzzone unterbrochen wird. Durch Aufschmelzen einer schmalen Zone ergibt sich jedoch eine Möglichkeit, diesen Effekt zu umgehen. Der Reaktor besteht aus einem Quarzrohr, das mit Wasserstoff gespült wird und mit einer Hochfrequenz-Spule beheizt wird. Das Si-beschichtete Substrat wird unter einem induktiv beheizten, im Reaktor befindlichen SiC-beschichteten Graphit-Stab (Heizer) hindurchgefahren. Der heiße Graphit-Stab strahlt Wärme ab und sorgt für eine Schmelzzone, die in der Mitte 2 cm breiter ist als am Rand des Substrates. Nach Kristallisation solcher Si-Schichten wird zu Herstellung einer Solarzelle zunächst eine 20 - 30 µm dicke p-leitende Siliciumschicht auf der kristallisierten Unterlage epitaktisch abgeschieden und darauf eine 0,2 - 0,4 µm dicke n-leitende Emitterschicht.

Nach M. Kerber, M. Bettini, E. Gornick, Proc. 17th IEEE Photovolt. Spec. Conf. 1984, Kissimee, p. 275, wird auf einem Graphitsubstrat zuerst eine hochdotierte n-leitende Si-Schicht abgeschieden, die danach mittels eines darübergeführten Wolframdrahtes als Strahlungsheizer aufgeschmolzen und rekristallisiert wird. Die optimale Dicke dieser Schicht wird mit 20 - 30 µm angegeben. Darüber wird nun die photovoltaische aktive n-leitende Schicht mit 60 - 100 µm Schichtdicke epitaxiert. Durch anschließende Spray-Pyrolyse von $SnO_2$ wird eine SIS-Solarzelle mit 9 % Wirkungsgrad hergestellt.

Beiden Verfahren ist gemeinsam, daß sich der Heizer für die Schmelzzone im Reaktionsraum unter Schutzgas ($H_2$) befindet. Es ist daher notwendig während des Aufschmelzens die Beschichtung zu unterbrechen. Andernfalls würde eine Si-Beschichtung der Heizer im Reaktor erfolgen.

Die in beiden Verfahren beschriebenen rekristallisierenden Siliciumschichten sind für die Herstellung der eingangs erwähnten Dünnschichtsolarzelle aus polykristallinem Silicium von insgesamt nur 20 - 50 µm Dicke zu dick. Auch besitzen die Schichten nicht die erforderliche Gitterperfektion für ein photovoltaisch einsetzbares Material, so daß darüber eine Epitaxie-Schicht von großer Dicke mit den geforderten photoelektrischen Eigenschaften aufgebracht werden muß.

Somit entfällt hier der prinzipiell bei Abscheidung aus der Gasphase mögliche wirtschaftliche Vorteil wieder dadurch, daß

1. zur Herstellung großer Kristalle eine dicke Schicht verwendet werden muß, die aber für photovoltaische Zwecke zu schlechte Gitterqualität besitzt,

2. darauf eine dicke Schicht abgeschieden werden muß, weil kein Rückseitenreflektor vorhanden ist, um das Sonnenlicht effektiv zu absorbieren.

Zudem haben eigene Versuche mit isostatisch gepreßten, hochdichten Graphit-Substraten (Porosität 12 %) ergeben, daß sich der Graphit beim Aufschmelzen des Silicium vollsaugt, so daß dünne Siliciumschichten im Graphit verschwinden und somit nicht rekristallisiert werden können. Eine Dünnschichtsolarzelle ist daher auf diese Weise nicht herstellbar.

Aus der US-A-4 077 818 ist eine multikristalline Solarzelle mit einem Trägermaterial aus Graphit bekannt. Auf dem Graphitträger wird Silicium in geeigneter Schichtdicke aufgetragen, um durch Reaktion mit dem Graphit eine SiC-Zwischenschicht herzustellen, durch die der Träger versiegelt wird.

Aus der Literaturstelle "Electronics, Bd. 60, Nr. 10, 14.05.87, Seite 22" ist eine Solarzelle bekannt, bei der auf einem keramischen Träger SiC als Reflexionsschicht aufgebracht ist.

In "Extended Abstracts, Bd. 80-1, Nr. 332. Mai 1980, Seiten 827-828" ist eine Solarzelle mit einem Träger aus Graphit beschrieben, der mit einer Kohlenstoffschicht abgedeckt ist, um ein Eindringen geschmolzenen Siliziums zu verhindern.

Schließlich ist der DE-B 1 223 951 ein Verfahren zur Herstellung eines Halbleiterbauelements mit zumindest einem PN-Übergang zu entnehmen, bei dem auf einem Träger eine Keimbildungsschicht durch Aufschmelzen aufgebracht wird. Das Material der Keimbildungsschicht kann in den Träger diffundieren, so daß das Halbleiterbauelement über einen langen Zeitraum betrachtet nicht stabil ist.

Der vorliegenden Erfindung liegt das Problem zugrunde, ein Verfahren der eingangs genannten Art weiterzubilden, um ein Halbleiter-Bauelement hohen Wirkungsgrades kostengünstig herzustellen, wobei gleichzeitig eine Langzeitstabilität des Halbleiter-Bauelementes selbst gewährleistet werden soll.

Das Problem wird erfindungsgemäß dadurch gelöst, dass auf den aus Graphit bestehenden oder Graphit enthaltenden Träger eine diesen versiegelnde Zwischenschicht aus polykristallinem und/oder amorphem SiC aufgetragen wird, die ein Eindringen von Material der Keimbildungsschicht verhindert und die gegenüber der Keimbildungsschicht bei einer Temperatur oberhalb deren Schmelzpunkt thermisch und chemisch stabil ist.

Hervorzuhebende Merkmale vermitteln die Unteransprüche.

Weitere Einzelheiten, Vorteile und Merkmale der Erfindung ergeben sich nicht nur aus den Ansprüchen, den diesen zu entnehmenden Merkmalen - für sich oder in Kombination -, sondern auch aus den der nachfolgenden Beschreibung eines der Zeichnung zu entnehmenden bevorzugten Ausführungsbeispiels.

Es zeigen:

Fig. 1      eine Prinzipdarstellung einer Anordnung zur Herstellung eines Halbleiter-Bauelements,

Fig. 2      eine alternative Ausführungsform einer Anordnung zur Herstellung eines Halbleiter-Bauelements,

Fig. 3      Ausbildung von Wärmequellen zum Aufschmelzen einer Keimbildungsschicht,

Fig. 4      eine Prinzipdarstellung zur Erläuterung eines Rekristallisationsvorgangs,

Fig. 5      einen Aufbau eines Halbleiter-Bauelementes,

Fig. 6      ein Schliffbild eines eine Keimbildungsschicht und eine Halbleiterschicht umfassenden Schichtaufbaus und

Fig. 7      eine Textur einer Epitaxieschicht eines Halbleiter-Bauelements.

Sofern erfindungsgemäß eine Dünnschichtsolarzelle hergestellt werden soll, wird ein Graphit oder Graphit enthaltender Träger vorzugsweise mit einem thermischen Ausdehnungskoeffizient wie Silicium benutzt.

Auf diesem Träger wird zuerst eine dichte feinkristalline, elektrisch leitfähige Zwischenschicht, vorzugsweise mit einem Brechungsindex kleiner als der von Silicium, in Schichtdicken von 1 bis ca. 100 μm, vorzugsweise 10 - 60 μm, abgeschieden. Diese Zwischenschicht dient zur Versiegelung des porösen Trägers wie Graphits und gleichzeitig sowohl als elektrischer Rückkontakt als auch diffuser Reflektor. Da Metalle mit Silicium bei den vorgesehenen Abscheidebedingungen reagieren und Legierungen bilden, sind stabile Verbindungen als Schichtmaterial notwendig. Hierzu können nicht im Rahmen dießer Erfindung besonders gut elektrisch leitfähige keramische Materialien aus diversen Metallborid-, Metallkarbid-oder Metallnitridverbindungen genommen werden, wobei solche Verbindungen bevorzugt werden, die Elemente der 3. Hauptgruppe oder 4. Hauptgruppe enthalten und keine Übergangselemente, da letztere bei Diffusion in Silicium bereits in geringen Konzentrationen zur Degradation der Solarzelle führen.

Erfindungsgemäß wird Siliciumcarbid (Bor- oder Aluminium-dotiertes SiC für p-Leitung, Stickstoff- oder Phosphor-dotiertes SiC für n-Leitung) mit einer definierten Rauhtiefeverwendet, welches aufgrund seiner Oberflächenstruktur eine diffus reflektierende Fläche darstellt. Wegen des kleineren Brechungsindex von SiC kommt es beim Austritt von Lichtstrahlen aus dem Silicium zur Totalreflexion an der Grenzfläche Si/SiC. Dies wiederum führt zu einer diffus reflektierenden Si/SiC-Grenzfläche.

Die dotierte SiC-Schicht kann auch gleichnamig dotiertes Silicium enthalten. Die SiC-Schicht kann im CVD-Verfahren hergestellt werden unter Verwendung von beheizten Substraten und Methyltrichlorsilan ($CH_3 SiCl_3$) und Wasserstoff. Alternativ dazu kann auch in Kombination ein Si-haltiges Chlorsilan ($SiHCl_3$, $SiCl_4$, $SiH_2Cl_2$) oder $SiH_4$ und Methan $CH_4$ anstelle von $CH_3SiCl_3$ eingesetzt werden.

Um p-Leitung zu erzeugen, werden geringe Mengen Dotiergas zugesetzt, z. B. $BCl_3$, $BBr_3$, $B_2H_6$ zur Bor-Dotierung oder Al-Verbindungen wie $AlCl_3$ oder $Al(CH_3)_3$ zur Aluminium-Dotierung.

Um n-Leitung zu erzeugen, kann $NH_3$ oder $N_2$ bzw. $PH_3$ oder $PCl_3$ als Dotiergas verwendet werden.

Um sodann eine Halbleiterschicht mit großen einkristallinen Bereichen auf dem Träger mit der feinkristallinen Zwischenschicht abzuscheiden, werden folgende Verfahrensmaßnahmen gewählt.

Zuerst wird mit einem beliebigen Herstellungsverfahren, vorzugsweise durch thermisches CVD-Verfahren (Reduktion von $SiHCl_3$ oder $SiCl_4$ in $H_2$ bei 900 - 1350 °C) eine dünne zusammenhängende Keimbildungsschicht abgeschieden. Danach wird die Keimbildungsschicht, zumindest in Teilen, aufgeschmolzen und mit einem Temperaturgradienten, der parallel zur Substratoberfläche oder zum Träger hin geneigt verläuft, langsam erstarrt.

Dabei bildet sich an einem Punkt der Fläche ein Si-Keim, der beim Abkühlen lateral über die Keimbildungsschicht wächst, so daß auf diese Weise ein großes Korn geringer Schichtdicke hergestellt werden kann.

Nachdem die Keimbildungsschicht ganz oder teilweise erstarrt ist, kann eine photovoltaisch geeignete Schicht bei einer tieferen Temperatur epitaktisch auf der Keimbildungsschicht abgeschieden werden.

Es ist dabei wichtig, darauf zu achten, daß die schmelzflüssige Keimbildungs-Si-Schicht keine Tropfen bildet, da Silicium dazu neigt. Dieses Problem tritt besonders bei großen Schichtdicken auf. Das Problem wird dadurch gelöst, daß die Keimbildungsschicht so dünn gewählt wird, daß die Adhäsionskräfte von Si und dem Zwischenschichtmaterial die Kohäsionskräfte im Si-Tropfen überwiegen.

Die SiC-Zwischenschicht wird in geeigneter Weise von Silicium benetzt. (Bei der Herstellung von Silicium-Tropfen auf einer polierten SiC-Schicht konnte ein Kontaktwinkel von 4 - 6° als Beweis für die gute Benetzung gemessen werden.)

Man kann den tropfenbildenden Effekt der Oberflächenspannung von flüssigem Silicium durch geeignete Strukturierung der Zwischenschichtfläche kompensieren, indem man mikroskopisch kleine Hohlräume oder Vertiefungen schafft, die als Kapillaren für das flüssige Silicium wirken. Dies kann auf besonders einfache Weise durch Aufrauhen der benetzbaren Zwischenschicht erreicht werden, so z. B. bei einer SiC-Zwischenschicht mit einer mittleren Rauhtiefe von 1 - 2 μm. Durch diese Kapillaritätskräfte können noch bis zu 10 μm dicke Silicium-Keimbildungsschichten ganzflächig auf der Zwischenschichtoberfläche gehalten werden, ohne Tropfen zu bilden, vorzugsweise werden aber Schichtdicken von 2 - 4 μm als Bekeimung eingesetzt.

Die Herstellung der Schicht geschieht in nachfolgend beschriebener Weise:

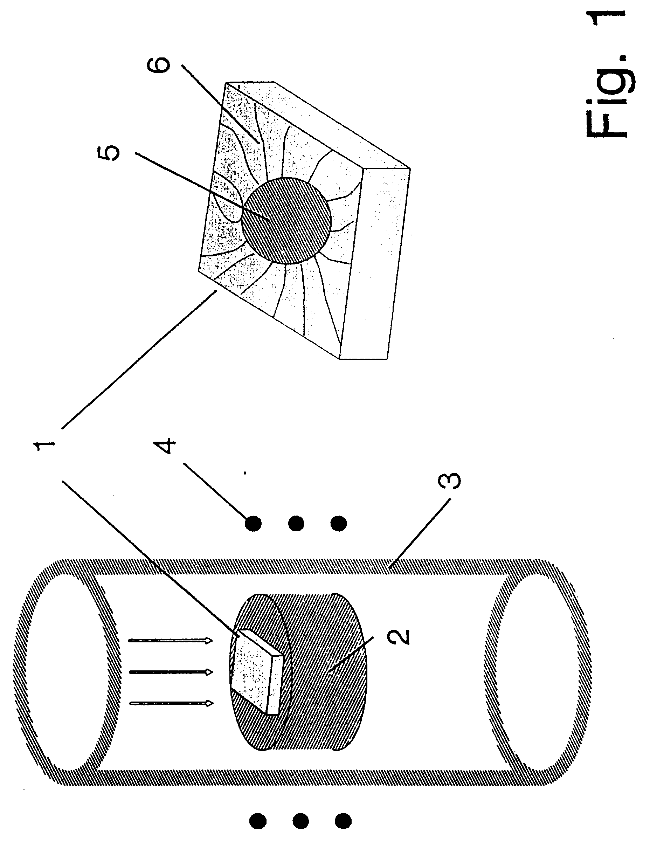

Als ein CVD-Reaktor (Fig. 1) wird ein Quarzreaktor (3) benutzt, in dem sich auf einem Graphithalter (2) ein Träger mit einer elektrisch leitfähigen Zwischenschicht (1) befindet. Bei letzterer handelt es sich um SiC. Der Träger mit der Zwischenschicht wird mittels einer HF-Spule (4) induktiv auf eine Temperatur von ca. 1100 °C aufgeheizt. Durch das zuvor evakuierte und gasgespülte Rohr werden $H_2$ und $SiHCl_3$ bzw. $SiCl_4$ geleitet, so daß sich am heißen Substrat eine 1 - 10 μm, vorzugsweise 4 μm dünne Siliciumschicht als Keimbildungsschicht abscheidet.

Nach der Abscheidung der Keimbildungsschicht wird die Temperatur der Schicht auf 1450 °C (oberhalb des Schmelzpunktes von Silicium) angehoben und die Schicht aufgeschmolzen. Danach wird die Schicht wieder abgekühlt und die Erstarrung erfolgt lateral von den vier Ecken ausgehend nach innen (Fig. 1, erstarrte Schicht (6), Schmelze (5)).

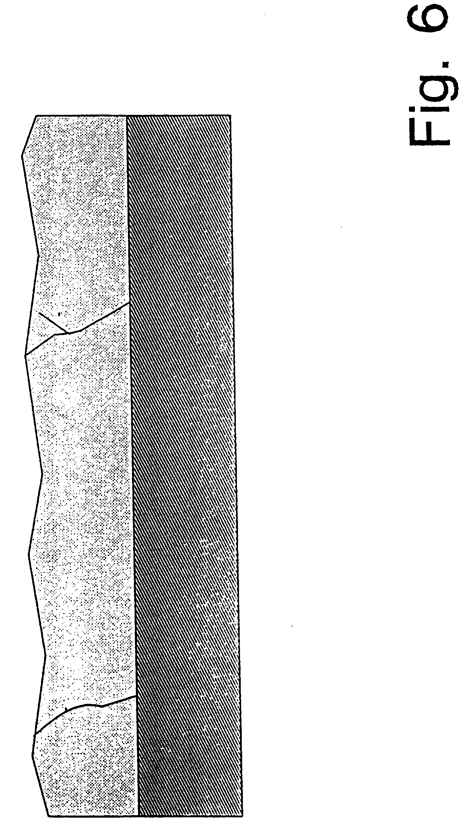

Nach vollständiger Erstarrung wird das Substrat wieder auf ca. 1100 °C abgekühlt. Sodann kann die Halbleiterschicht aufgetragen werden. Auf diese Weise erhält man einen zusammenhängenden Schichtaufbau mit senkrechten Korngrenzen zur Substratoberfläche und Korngrößen von 100 μm - 300 μm (s. Fig. 6).

Prinzipiell ist diese Art der Herstellung auf jedem anderen Material möglich, das von Silicium benetzt wird und dessen Porosität so klein ist, daß sich das Material nicht vollsaugt. Es kann ein beliebiges Substratmaterial verwendet werden, das die Randbedingungen einer porenfreien Oberfläche auf der der Keimbildungsschicht zugewandten Fläche und der thermischen und chemischen Stabilität gegenüber den hohen Temperaturen und verwendeten Medien erfüllt.

Um dies alles sicherzustellen und um kostengünstigeren graphit als Trägermaterial zu verwenden, ist jedoch erfindungsgemäß vorgesehen, daß die Trägeroberfläche mit einer feinkristallinen, dichten, elektrisch leitfähigen SiC-Schicht überzogen wird. Es ist von Wichtigkeit, daß die SiC-Schicht aus länglichen kolumnaren Kristalliten besteht, mit einer Oberflächenrauhigkeit von ca. 1- 2 μm ($R_A$-Wert). Die Schichtdicke beträgt vorzugsweise 20 - 100 μm und der Abstand von Spitze zu Spitze ist etwa 1 - 5 μm.

Hieraus ergeben sich wiederum zwei Realisierungsmöglichkeiten, die nacheinander getrennt angeführt werden.

Fall 1:

Zwischen der SiC-Zwischenschicht und dem Träger besteht eine gute Haftfestigkeit. Dann verbleibt der Träger unter der Zwischenschicht und bildet den eigentlichen Träger. Es sind dann Materialien einzusetzen, deren thermischer Ausdehnungskoeffizient möglichst nahe bei Silicium liegt ($4 \times 10^{-6}$ $K^{-1}$).

Die Substratoberfläche kann eine Porosität aufweisen, an die keine hohen Anforderungen gestellt wird. Eine hohe Temperaturbeständigkeit ist erforderlich. Die gewünschte thermische Ausdehnung kann durch Mischen von mindestens zwei Komponenten, im allgemeinen Fall von n-Komponenten, eingestellt werden, indem feinkörnige Pulver homogen vermischt werden, deren Stoffmengenanteile die Abweichungen im Ausdehnungskoeffizienten von Silicium wieder kompensieren.

Fall 2:

Eine weitere Lösungsmöglichkeit besteht darin, zunächst eine SiC-Schicht auf einem Material, vorzugsweise einer Graphitsorte, mit einem thermischen Ausdehnungskoeffizienten, der deutlich verschieden von Siliciumcarbid ($4 \times 10^{-6}$ $K^{-1}$) ist und vorzugsweise $8-9 \times 10^{-6}$ $K^{-1}$ beträgt, abzuscheiden.

Durch Abkühlen erreicht man ein Abplatzen der SiC-Schicht, die nun ihrerseits als Trägermaterial zur Si-Beschichtung eingesetzt wird. Das Graphit-Substrat kann hiernach erneut eingesetzt werden.

Die SiC-Zwischenschicht versiegelt das poröse Trägersubstratmaterial und verhindert dadurch, daß beim Aufschmelzen des Keimbildungsschichtmaterials (flüssiges Silicium) dieses in das poröse Substratmaterial eindringt. Außerdem sorgt die durch die Rauhigkeit hergestellte Hohlraumstruktur im μm-Bereich für eine durch Kapillaritätskräfte stark verbesserte Benetzung der Trägeroberfläche. Wenn diese Schicht ausreichend elektrische Leitfähigkeit besitzt, kann auch ein Isolator als Substratmaterial eingesetzt werden, was Voraussetzung für die integrierte Serienverschaltung von polykristallinen Dünnschichtmodulen ist. Es können flüssige Si-Schichten bis zu 10 μm gleichmäßig ohne Tropfenbildung gehalten werden. Damit ist die Schichtdicke der flüssigen Schicht dick im Vergleich zur Oberflächenrauhigkeit des Substrats, wodurch ein störungsarmes, laterales Kristallwachstum in der dünnen Schicht erzielt werden kann.

Eine weitere Verbesserung des Kristallwachstums läßt sich erreichen, wenn man die SiC-Zwischenschicht in einem $BCl_3/H_2$-Gemisch bei hohen Temperaturen (1100 - 1500 °C) tempert, oder indem man die SiC-Zwischenschicht während der Abscheidung mit Bor dotiert. Die dadurch erreichte Modifikation der SiC-Oberfläche bewirkt eine Glättung der Schichtrauhigkeit ohne eine merkliche Änderung der Rauhtiefe, was das Wachstum Quadratmillimeter großer einkristalliner Bereiche ermöglicht.

Mit der oben beschriebenen Versuchsanordnung, Fig. 1, lassen sich bereits einige Quadratmillimeter große einkristalline Bereiche herstellen.

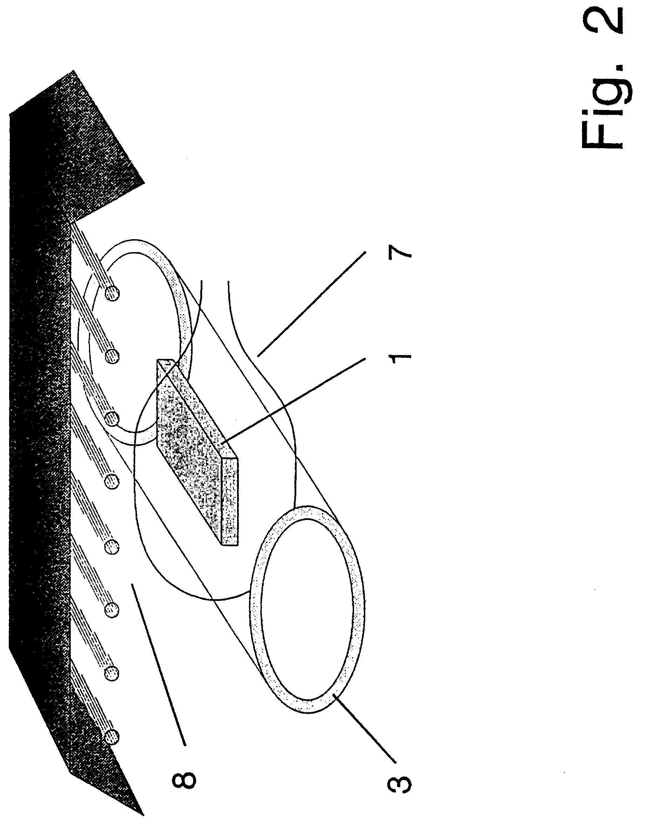

Eine weitere Verbesserung wird mit der nachfolgend beschriebenen Anordnung erreicht (Fig. 2):

Der Träger (1) wird in einem Strahlungsfeld (8), vorzugsweise zwischen zwei Strahlungsfeldern angeordnet, die eine Grundtemperatur von 900 - 1350 °C auf dem Träger ergeben.

Im Strahlungsfeld befindet sich ein Quarzrohr (3) als Reaktor, durch das Chlorsilanverbindungen als Reaktionsgase, vorzugsweise $SiHCl_3$, $SiCl_4$ und Wasserstoff im geeigneten Mischungsverhältnis geleitet werden. Eine intensive Luftkühlung des Quarzreaktors (3) sorgt dafür, daß die Quarzwand sich nicht zu stark aufheizt, so daß Wandbelege aus Reaktionsprodukten vermieden werden. Über dem Träger oder Substrat (1) ist eine vorzugsweise gekrümmte Leiterschleife (7) ausgebildet, die über das Substrat (1) gefahren werden kann. Schickt man einen Hoch-/Mittelfrequenzstrom durch den Leiter, so kann eine schmale Zone des Substrates auf Temperaturen oberhalb des Si-Schmelzpunktes induktiv aufgeheizt werden.

Es wird nun zuerst eine dünne Siliciumkeimbildungsschicht, 1 - 10 µm, vorzugsweise 4 µm, abgeschieden bei 900 °C - 1350 °C, vorzugsweise bei ca. 1100 °C. Danach wird die Spule über die Keimbildungsschicht mit konstanter Geschwindigkeit bewegt, so daß eine schmale Schmelzzone durch die Keimbildungsschicht wandert. Beim Abkühlen kristallisiert das Material lateral, so daß sich große Körner ausbilden können. Auf der erstarrten Keimbildungsschicht wird sodann eine Halbleiterschicht wie Si-Schicht bei einer Grundtemperatur epitaktisch abgeschieden.

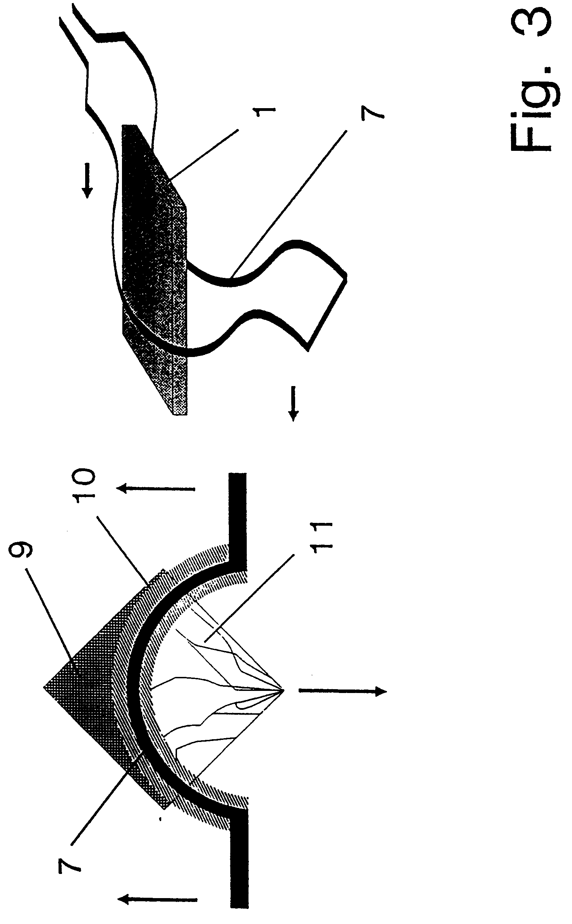

Durch gekrümmte Ausführung der HF-Leiterschleife (7) (Fig. 3) erreicht man eine zusätzliche Vergrößerung des Kristallwachstums durch Keimauslese während der lateralen Kristallisation. Die Keimbildungsschicht kristallisiert während des gesamten Prozesses mit definiert einstellbarer konvexer Erstarrungsfront. In Fig. 3 sind gekennzeichnet die feinkristalline Si-Keimbildungsschicht (9), die schmale Schmelzzone (10) und die kristallisierte Keimbildungsschicht (11). Die Phasengrenze (Übergang (10) zu (11) ist konvex geformt. Dies ist ein wesentlicher Unterschied zu Chu et. al., J. Appl. Phys. 48 (1977) 3576, der aufgrund seiner konvexen Schmelzzone eine konkave Erstarrungsfront erzeugt.

Eine konvexe Erstarrangsfront ist Voraussetzung für stabiles Kristallwachstum.

Mit Hilfe dieser Anordnung läßt sich nun ein Bauelement wie Solarzelle oder eine Halbleiterstruktur wie Träger/Rückkontakt/p-Si-Schicht/n-Si-Schicht herstellen. Zunächst wird das Quarzrohr evakuiert und gespült. Danach wird der mit dem Rückkontaktmaterial beschichtete Träger in den Reaktor eingeführt und mit Hilfe der Strahlungsheizung auf 900 - 1350 °C aufgeheizt. Nach Zugabe der Reaktionsgase $H_2$, $SiHCl_3$, $BCl_3$ wird eine dünne Keimbildungsschicht auf den Träger abgeschieden.

Danach wird die Keimbildungsschicht durch ein Zonenschmelzen aufgeschmolzen und mit konvexer Erstarrungsfront langsam kristallisiert. Auf diese Schicht wird eine dicke multikristalline, p-dotierte Si-Schicht abgeschieden. Danach wird die Kammer evakuiert, erneut geflutet und dann eine Phosphor dotierte n-leitende Schicht (0,1 µm bis einige µm dick) abgeschieden. Diese Halbleiterschicht wird definiert abgekühlt. Danach wird die Probe mit einem siebgedruckten Frontgitter versehen.

Durch hohe Dotierung der Keimbildungsschicht mit Bor wird zur Passivierung der Rekombination von Ladungsträgern an der Grenzfläche Epitaxieschicht/Keimbildungsschicht ein BSF ("back surface field") hergestellt.

Die Keimbildungsschicht dient auch als Gatterschicht zur Aufnahme von Verunreinigungen aus dem Substrat.

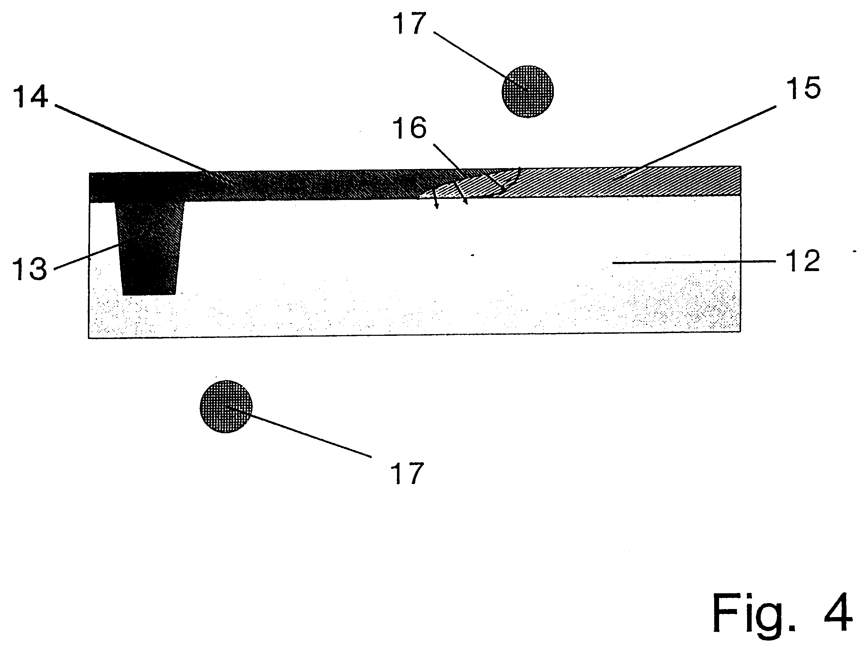

Eine gezielte Orientierung der Keimbildungsschicht ist durch Einarbeitung geringer Mengen monokristallinen Materials in das Substrat möglich (Fig. 4). Ein einkristalliner Keim (13) mit (100)-Orientierung wird in den Träger eingelassen, so daß seine Oberfläche mit der Trägeroberfläche abschließt. Nach Erreichen der Grundtemperatur von ca. 1000 °C wird der Träger einschließlich des Si-Keims mit der dünnen Si-Keimbildungsschicht beschichtet. Danach wird die Induktions-Spule (17) über den Träger geschoben und die Keimbildungsschicht aufgeschmolzen. Aufgrund der höheren elektrischen Leitfähigkeit der Si-Keimbildungsschichtschmelze (15) wird die Keimbildungsschicht durch das stärkere Einkoppeln der elektrischen Energie ca. 100 °C heißer als der Träger. Der Prozeß wird so geführt, daß der Kein, aufgrund seines kleineren Durchmessers und wegen der Kühlung durch den Träger nur teilweise aufgeschmolzen wird.

Beim Erstarren kann dann die Orientierung des Keimes für die kristallisierende Keimbildungsschicht (14) wirksam werden. Mit diese Methode können auch monokristalline, orientierte Keimbildungsschichten (14) auf polykristallinen Substraten (12) erzielt werden.

Eine weitere Reinigung der Keimbildungsschicht (14) und damit der nachfolgenden Epitaxie-Halbleiterschicht wird erreicht, wenn man den lateralen Erstarrungsprozeß so führt, daß die Erstarrungsfront (16) nicht senkrecht zur Substratoberfläche verläuft, sondern unter einem flachen Winkel, wobei die Si-Keimbildungsschicht an der Oberfläche zuerst erstarrt.

Dies wird dadurch erzielt, daß die Leiterschleife ( (7) in Fig. 3, (17) in Fig. 4) schräg gestellt wird oder nur der über der Schicht gelegene Teil der Leiterschleife konvex ausgeführt wird (Fig. 3). Störungen auf dem Substrat werden für die Oberfläche der Keimschicht nicht mehr wirksam, was die Voraussetzung für monokristallines Schichtwachstum ist. Außerdem werden Verunreinigungen mit einem Verteilungskoeffizienten kleiner als 1 an der Grenzfläche Silicium/Substrat (Träger) (bzw. Rückkontakt) und nicht in der Schicht angereichert.

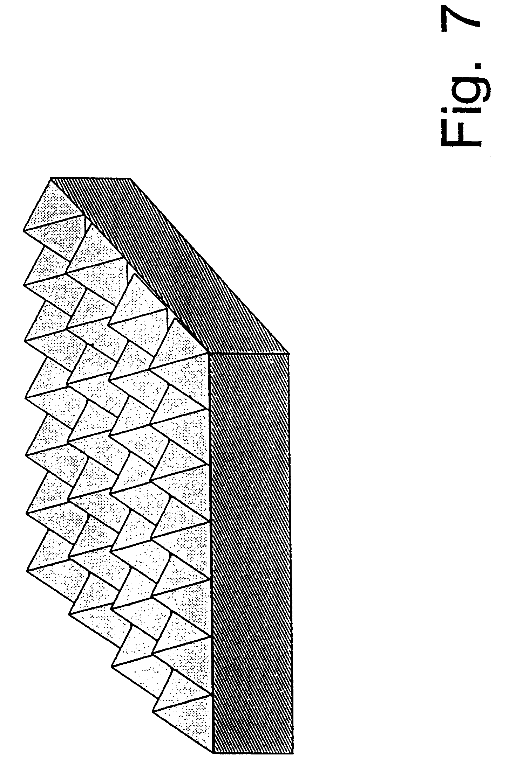

Durch Auswahl einer geeigneten Grundorientierung der Keim-Schicht (z. B. 100-Orientierung bzw. 111-Orientiertung) kann die Epitaxie-Schicht mit einer Textur versehen werden, was für Solarzellen von Vorteil ist. Fig. 7 zeigt das pyramidenähnliche Wachstum, einer solchen Oberfläche. In diesen Pyramiden wird das Licht besser eingefangen und angelenkt, was wiederum zu einer verbesserten Lichtabsorption führt.

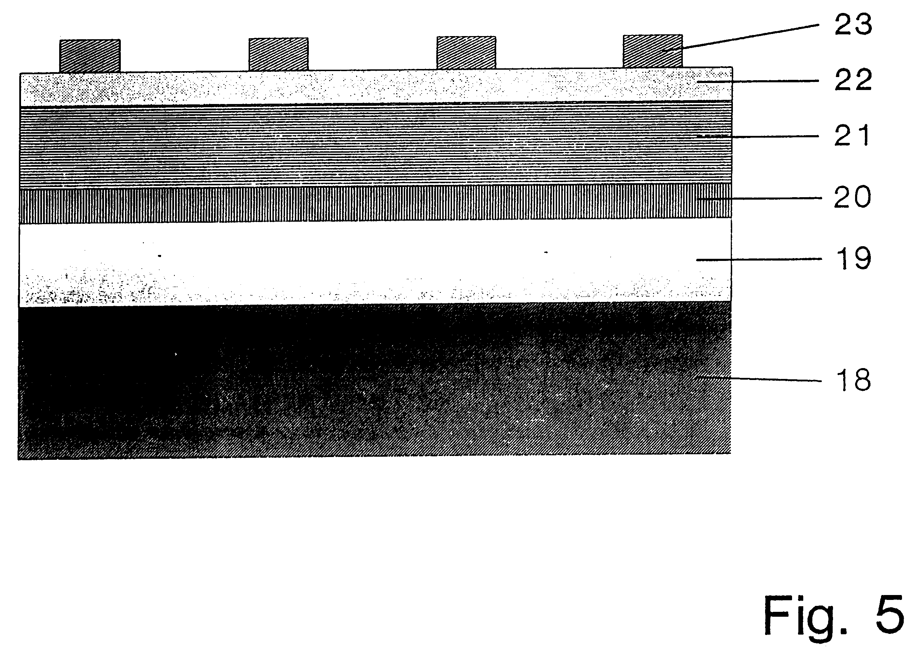

In Fig. 5 ist der Schichtenaufbau einer Dünnschichtsolarzelle, die mit dem beschriebenen Verfahren hergestellt wird, wiedergegeben. Es bedeuten (18) der Träger (Graphitsubstrat). Darauf wird eine elektrisch leitfähige SiC-Zwischenschicht (19) abgeschieden, die vorzugsweise 20 - 100 μm dick ist, p-leitend ist, eine Oberflächenrauhigkeit von 1 - 2 μm besitzt und gleichzeitig als Versiegelungsschicht, diffuser Reflektor und Rückkontakt dient.

Darüber wird die dünne Keimbildungsschicht (20), die vorzugsweise 4 μm dick, p-leitend und hochdotiert ist, ausgebildet. Darauf wird die photovoltaisch empfindliche Epitaxieschicht (21) (Schichtdicke 5 μm bis 400 μm, vorzugsweise 10 - 30 μm) abgeschieden. Darüber befindet sich die n-Schicht (22) und der Frontkontakt (23). Anstelle der Schicht (22) kann auch eine MIS-Inversionsschichtsolarzelle auf der Epitaxieschicht (21) hergestellt werden.

Ist zuvor die erfindungsgemäße Lehre an Hand einer Dünnschichtsolarzelle erläutert worden, so können auch Halbleiter-Bauelemente wie Photodetektor oder Dünnschichttransistoranordnungen erfindungsgemäß hergestellt werden.

**Patentansprüche**

1. Verfahren zur Herstellung eines Halbleiter-Bauelementes, insbesondere Dünnschicht-Halbleiter-Bauelementes wie Dünnschicht-Solarzelle, umfassend einen Träger (1, 12, 18), erste und zweite elektrisch leitende Front- bzw. Rückkontakt (19, 23) bildende Kontakte sowie zumindest eine zwischen diesen vorhandene Halbleiterschicht (21, 22) und eine zwischen der Halbleiterschicht und dem Träger angeordnete Keimbildungsschicht (6, 9, 14, 20), die nach dem Auftragen zunächst lateral kristallisiert wird, um anschließend die Halbleiterschicht epitaktisch auf die Keimbildungsschicht abzuscheiden, **dadurch gekennzeichnet,** dass auf den aus Graphit bestehenden oder Graphit enthaltenden Träger (1, 18) eine diesen versiegelnde Zwischenschicht (19) aus polykristallinem und/oder amorphem SiC aufgetragen wird, die ein Eindringen von Material der Keimbildungsschicht verhindert und die gegenüber der Keimbildungsschicht (6, 9, 14, 20) bei einer Temperatur oberhalb deren Schmelzpunkt thermisch und chemisch stabil ist.

2. Verfahren nach Anspruch 1, **dadurch gekennzeichnet**, daß die Keimbildungsschicht (6, 9, 14, 20) einer derartigen lateralen Kristallisation mit einem in Richtung des Trägers (1, 12, 18) geneigten Temperaturgradienten unterzogen wird, daß sich in einer parallel zum Träger (1, 12, 18) verlaufenden Ebene eine konvex verlaufende Erstarrungsfront zwischen kristallisiertem Keimbildungsschichtbereich (11) und geschmolzenem Keimbildungsschichtbereich (10) ausbildet.

3. Verfahren nach Anspruch 1, **dadurch gekennzeichnet**, daß das Aufschmelzen der Keimbildungschicht (6, 9, 14, 20) in einem flächig vorspringenden Bereich oder einem Eckbereich der Keimbildungsschicht eingeleitet wird und/oder daß ein orientierter Keim in den Träger (1, 12, 18) eingelassen wird, und dieser beim Auftragen und Aufschmelzen der Keimbildungsschicht nur teilweise derart aufgeschmolzen wird, daß ein orientiertes laterales Kristallwachstum der kristallierenden Keimbildungsschicht erfolgt.

4. Verfahren nach zumindest einem der vorhergehenden Ansprüche, **dadurch gekennzeichnet**, daß die den Träger (1, 12, 18) versiegelnde Zwischenschicht (19) eine kontrolliert vorgegebene Oberflächenrauhigkeit durch z.B. Art der Abscheidung der Zwischenschicht, durch Anätzen dieser und/oder mechanisches Bearbeiten aufweist.

5. Verfahren nach Anspruch 4, **dadurch gekennzeichnet**, daß die Zwischenschicht (19) vor Auftragen der Keimbildungsschicht (20) in einem Gemisch aus Wasserstoff und zumindest einer flüchtigen Borverbindung wie $BBr_3$, $B_2H_6$, vorzugsweise $BCl_3$ getempert wird.

6. Verfahren nach zumindest einem der vorhergehenden Ansprüche, **dadurch gekennzeichnet**,

daß die Keimbildungsschicht (6, 9, 14, 20) derart orientiert wird, daß die anschließend epitaktisch aufgetragene Halbleiterschicht (21) mit texturierter Oberfläche wächst.

7. Verfahren nach zumindest einem der vorhergehenden Ansprüche,
   **dadurch gekennzeichnet**,
   daß die laterale Erstarrung der Keimbildungsschicht (6, 9, 14, 20) derart erfolgt, daß Verunreinigungen des Keimbildungsschichtmaterials an der Grenzfläche zwischen der Keimbildungsschicht und der Zwischenschicht (19) angereichert werden.

8. Verfahren nach einem der vorhergehenden Ansprüche,
   **dadurch gekennzeichnet**,
   dass in der Zwischenschicht (19) als zusätzlichs Material Silizium verwendet wird.

## Claims

1. A method for the manufacture of a semiconductor component, in particular of a thin-film semiconductor component such as a thin-film solar cell, comprising a substrate (1, 12, 18), first and second electrically conducting contacts forming a front and rear contact (19, 23) respectively, as well as at least one nucleation film or layer (6, 9, 14, 20) disposed between said semiconductor film or layer (21, 22) and one between the semiconductor film or layer and the substrate, this nucleation film being initially applied and then laterally crystallized, with the semiconductor film or layer then being epiaxially deposited onto the nucleation film or layer,
   **wherein**
   an intermediate film (19) made from polycrystalline and/or amorphous silicon carbide is applied, thus sealing the substrate (1, 18) made from or containing graphite, said intermediate film preventing penetration of the material forming the nucleation film and being thermally and chemically stable in respect of the nucleation film (6, 9, 14, 20) at a temperature above its melting point.

2. A method according to Claim 1,
   **wherein**
   the nucleation film (6, 9, 14, 20) is subjected to lateral crystallization with a temperature gradient inclined in the direction of the substrate (1, 12, 18) such that, in a plane parallel to said substrate (1, 12, 18) a convex-shaped solidification contour is obtained between the crystallized nucleation film (11) and the molten part of said nucleation film.

3. A method according to Claim 1,
   **wherein**
   melting of said nucleation film (6, 9, 14, 20) is initiated in a projecting area or in a corner area of the nucleation film, and/or that an oriented nucleus is inserted into said substrate (1, 12, 18), and said oriented nucleus is only partially melted while depositing and melting said nucleation film, whereby oriented lateral crystal growth takes place in said nucleation film.

4. A method according to at least one of the above claims,
   **wherein**
   the surface of the intermediate film (19) sealing the substrate (1, 12, 18) is roughened according to specifications, for example, by the method in which said intermediate film is deposited, by cauterizing said intermediate film and/or by mechanical processing.

5. A method according to Claim 4,
   **wherein**
   the intermediate film (19) is tempered in a mixture of hydrogen and at least one volatile boron compound selected from the group consisting of $BBr_3$, $B_2H_6$, preferably $BCl_3$, prior to deposition of said nucleation film.

6. A method according to at least one of the above claims,
   **wherein**
   said nucleation film (6, 9, 14, 20) is oriented such that said semiconductor film (21) is then epitaxially deposited with a textured surface.

7. A method according to at least one of the above claims,
   **wherein**
   lateral solidification of said nucleation film (6, 9, 14, 20) is obtained in such a way that impurities in the nucleation film material are concentrated at the interface between said nucleation film and said intermediate film (19).

8. A method according to one of the above claims,
   **wherein**
   silicon is used in the intermediate film (19) as an additional material.

## Revendications

1. Procédé de fabrication d'un composant semi-conducteur notamment d'un semi-conducteur en couches minces tel qu'une cellule solaire en couches minces, comprenant un support (1, 12, 18), un premier et un second contacts électriques de façade et de dos (19, 23) ainsi qu'au moins une couche semi-conductrice (21, 22) prévue entre ces contacts, et une couche de formation de germes (6, 9, 14, 20) prévue entre la couche semi-conductrice et le support, et que l'on cristallise tout d'abord latéralement après application pour ensuite déposer la couche semi-conductrice par voie épitaxiale sur la couche de formation de germes,
caractérisé en ce que
sur le support (1, 18) en graphite ou contenant du graphite, on dépose une couche intermédiaire (19) qui en assure le scellement, cette couche étant en SiC polycristallin et/ou amorphe, pour éviter la pénétration de matière dans la couche formant les germes et cette couche est thermiquement et chimiquement stable vis-à-vis de la couche de formation de germes (6, 9, 14, 20) à une température supérieure au point de fusion.

2. Procédé selon la revendication 1,
caractérisé en ce que
la couche de formation de germes (6, 9, 14, 20) est soumise à une cristallisation latérale avec un gradient de température incliné en direction du support (1, 12, 18) tel qu'il se développe un front de solidification de forme convexe dans un plan parallèle au support (1, 12, 18) entre la zone de la couche de formation de germes en cristallisation (11) et la zone de couche de formation de germes fondue (10).

3. Procédé selon la revendication 1,
caractérisé en ce qu'
on induit la fusion de la couche de formation de germes (6, 9, 14, 20) dans une zone venant en saillie par une surface ou dans une zone de coin de la couche de formation de germes et/ou en ce qu'on introduit un germe orienté dans le support (1, 12, 18) et lors de l'application et de la fusion de la couche de formation de germes, on ne fait fondre que partiellement pour avoir une croissance cristalline d'orientation latérale de la couche de formation de germes en cristallisation.

4. Procédé selon au moins l'une des revendications précédentes,
caractérisé en ce que
la couche intermédiaire (19) qui assure le scellement du support (1, 12, 18) présente une rugosité de surface prédéterminée, contrôlée, obtenue par exemple par une sorte de dépôt d'une couche intermédiaire, par amorçage d'attaque chimique de celle-ci et/ou traitement mécanique.

5. Procédé selon la revendication 4,
caractérisé en ce que
la couche intermédiaire (19) est trempée avant application de la couche de formation de germes (20) dans un mélange d'hydrogène et d'au moins une liaison de bore, volatile telle que $BBr_3$, $B_2H_6$ et de préférence $BCl_3$.

6. Procédé selon au moins l'une des revendications précédentes,
caractérisé en ce que
la couche de formation de germes (6, 9, 14, 20) est orientée pour développer ensuite par voie épitaxiale, la couche semi-conductrice (21), avec une surface texturée.

7. Procédé selon au moins l'une des revendications précédentes,
caractérisé en ce que
le figeage latéral de la couche de formation de germes (6, 9, 14, 20) se fait par enrichissement d'impuretés de la matière de la couche de formation de germes au niveau de la surface limite entre la couche de formation de germes et la couche intermédiaire (19).

8. Procédé selon l'une quelconque des revendications précédentes,
caractérisé en ce que
dans la couche intermédiaire (19), on utilise du silicium comme matière supplémentaire.

EP 0 536 682 B1

**Fig. 1**

EP 0 536 682 B1

Fig. 2

Fig. 3

Fig. 4

EP 0 536 682 B1

Fig. 5

23 22 21 20 19 18

Fig. 6

Fig. 7